# EUROPEAN PATENT SPECIFICATION

(11) **EP 2 136 423 B1**
(45) Date of publication and mention of the grant of the patent: **01.05.2013**
(21) Application number: 08425392.1
(22) Date of filing: 30.05.2008
(51) Int. Cl.: H01L 51/52, C23C 14/06, C23C 16/30

(54) **Multilayer coating for protecting organic optic devices and manufacturing process thereof**
Mehrschichtige Beschichtung zum Schutz von organisch optischen Vorrichtungen und Herstellungsprozess dafür
Revêtement multi-couche pour la production d'éléments optique à base organique et procédé pour la préparation de celui-ci

(43) Date of publication of application: 23.12.2009
(73) Proprietor: Centro Ricerche Plast-Optica S.p.A., 33020 Amaro (UD) (IT)
(72) Inventor: Melpignano, Patrizia, 33020 Amaro (Udine) (IT); Biondo Viviana, 33020 Amaro (Udine) (IT); Sinesi, Sabino, 33020 Amaro (Udine) (IT)
(74) Representative: Freyria Fava, Cristina

(56) References cited:
- WO-A-2006/063388
- DE-A1- 19 824 364

## Description

### Field of the invention

The present invention relates to the protection of organic optical devices from atmospheric agents, in particular water vapour and molecular oxygen.

### Technological background

Organic optical devices are opto-electronic devices capable of emitting light of their own by exploiting the electroluminescent capacities of organic materials that can be of a polymeric or non-polymeric nature. Examples of organic optical devices known in the art are light-emitting organic field-effect transistors, organic lasers and OLED devices. All these devices are **characterized in that** they are made on plastic, glass, metal or silicon substrates.

Light-emitting organic material is a material that is rapidly degraded by the water vapour and the oxygen molecules present in the environments.

It is hence indispensable, for use of these organic optical devices, to apply, on their outer surfaces, a protective coating impermeable to water vapour and to molecular oxygen.

Generally, the protective coatings are constituted by multilayer systems made up of a layer of acrylic polymeric material applied directly on the optical device and of one or more inorganic layers basically made up of alumina or silica that perform the function of barrier in regard to atmospheric agents. There are also known multilayer protective coatings including inorganic layers made up of silicon nitride or non-stoichiometric silicon nitrides.

The Japanese patent application No. JP-A-09270295 describes a polymeric coating for organic hexamethyldisiloxane-, hexamethylsilane-, trifluoropropyldimethylsiloxane- or trifluoropropyldimethyldisiloxane-based optical devices.

The international application WO-A-2006/063388 discloses a multilayer polymeric coating wherein the polymer is an organosilicon-based polymer.

Even though the protective coatings described above have enabled good levels of protection of the light-emitting organic layers to be achieved, there is still felt the need to develop coatings having improved protective capacities.

### Summary of the invention

The object of the present invention is the development of a new multilayer coating for protecting an organic optical device more effectively than what has so far been described.

The object of the present invention is achieved thanks to the solution recalled in the ensuing claims. The claims form an integral part of the technical teaching provided herein in regard to the invention.

In an embodiment of the present solution, the multilayer coating useful for protecting an organic optical device includes at least one first layer and one second layer, where the first layer is constituted by a hexamethyldisiloxane-based polymeric layer and the second layer is constituted by a perfluorohexane-based inorganic layer.

In a different embodiment, the multilayer coating includes a first hexamethyldisiloxane-based polymeric layer, a second perfluorohexane-based inorganic layer, and an intermediate layer between the first and second layers, where the intermediate layer is an SiOₓ-based inorganic layer.

Another embodiment of the present solution relates to a process for the production of the multilayer coating described above on an organic optical device. In particular, the process described herein envisages the deposition by means of the RF sputtering technique of a first hexamethyldisiloxane-based layer and the subsequent deposition by means of evaporation in a vacuum of the perfluorohexane-based layer.

### Detailed description of the invention

The invention will now be described in detail, purely by way of non-limiting example, with reference to the annexed figures, wherein:
- Figure 1 illustrates a diagram of the structure of a first embodiment of a multilayer coating, as described herein;
- Figure 2 illustrates a diagram of the process of plasma-assisted polymerization of hexamethyldisiloxane on an organic optical device; and
- Figure 3 illustrates a diagram of the structure of a second embodiment of a multilayer coating, as described herein.

Illustrated in the ensuing description are the various specific details, with the aim of providing an in-depth understanding of the embodiments. The embodiments can be obtained without one or more of the specific details, with other processes, components, materials etc. In other cases, known structures, materials or operations have not been described in detail so that the various aspects of the embodiments will not be obscured.

The reference to "an embodiment" in the framework of this description is intended to mean that a particular configuration, structure or characteristic described in relation to the embodiment is included in at least one embodiment. Hence, phrases such as "in an embodiment", which may be present in different points of this description, do not necessarily refer to the same embodiment. Furthermore, particular conformations, structures, or characteristics can be combined in any adequate way in one or more embodiments.

The reference numbers used herein are provided merely for reasons of convenience and hence do not define the sphere of protection or the scope of the embodiments.

One embodiment of the solution described herein relates to a new multilayer protective coating capable of guaranteeing values of permeability to molecular oxygen and water vapour that are improved with respect to what has so far been obtained with recourse to the known solutions.

Specifically, the multilayer coating includes at least one first layer and one second layer, where the first layer is a hexamethyldisiloxane-based polymeric layer and the second layer is a perfluorohexane-based inorganic layer, where the two layers can number from two to twelve.

Alternatively, the multilayer coating can include an intermediate layer between the first and second layers, where said intermediate layer is an SiO_{X}-based inorganic layer.

The presence of the perfluorohexane-based layer enables further improvement of the capacities of barrier to the atmospheric agents, given that said layer is markedly hydrophobic. Preferably, the perfluorohexane layer constitutes the outermost layer of the multilayer coating.

In particular, the multilayer protective coating described herein is able to guarantee at a temperature of approximately 25°C values of permeability to water vapour of 10⁻⁵ gr/m²/g and to molecular oxygen of 10⁻⁵ cc/m²/g.

The multilayer protective coating is applied on the outer surfaces of the organic optical device for the purpose of guaranteeing a complete sealing of the device with respect to the external environment. In the case where the organic optical device is an OLED device, there may be envisaged the provision of a first multilayer protective coating on the substrate of the OLED device and of a second multilayer protective coating applied on the thin metal film constituting the cathode of the OLED.

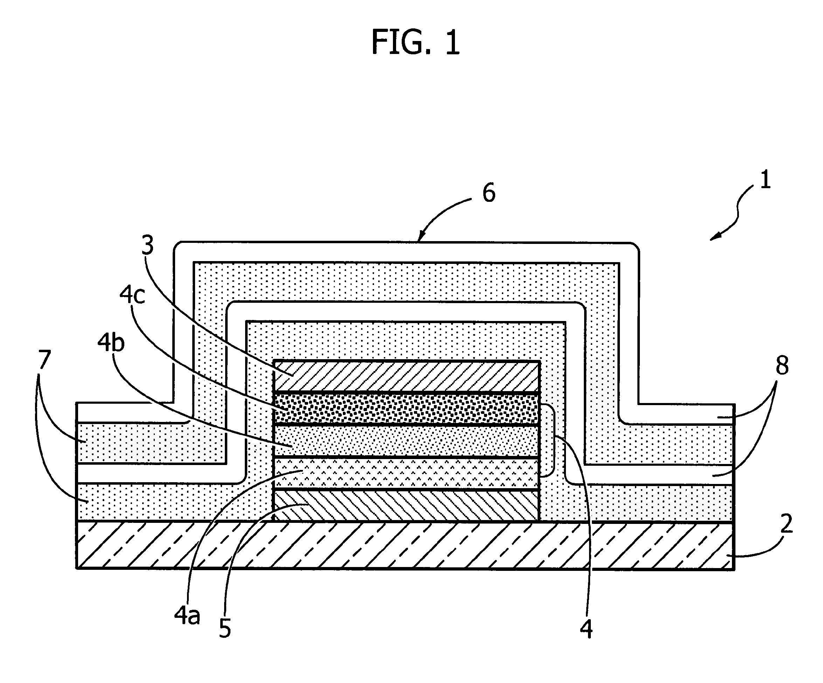

With reference to Figure 1, the OLED device - designated as a whole by the reference number 1, includes a substrate 2, deposited on which are an anode 3, a light-emitting organic layer 4 (in turn constituted, for example, by a series of three organic layers 4a, 4b and 4c) and a cathode 5. The device 1 is protected from atmospheric agents by the presence of a multilayer protective coating 6, constituted by an alternating series of hexamethyldisiloxane-based polymeric layers 7 and perfluorohexane-based inorganic layers 8.

The multilayer protective coating 6 is applied both on the cathode 5, and on the portion of substrate 2 not in contact with the outermost region of the anode 3 so as to seal the organic layers 4 of the device 1 completely from the external environment, guaranteeing in any case the electrical contact.

The multilayer protective coating 6 is applied on the device 1 with the first hexamethyldisiloxane-based layer 7 in direct contact with the cathode 5 and the outermost perfluorohexane-based layer. In the case where the multilayer coating 6 presents an odd number of layers and, hence, the outermost layer is a hexamethyldisiloxane-based layer, said outer layer may be to advantage functionalized with apolar groups to improve its hydrofobicity.

It is in general envisaged to apply initially on the organic optical device a first hexamethyldisiloxane-based layer and subsequently the perfluorohexane-based layer in such a way as to guarantee a good adhesion of the perfluorohexane layer.

The multilayer coating 6 can include from two to twelve layers with alternating hexamethyldisiloxane-based and perfluorohexane-based composition.

In a further embodiment, the multilayer coating 6 can include a first hexamethyldisiloxane-based layer 7 - in direct contact with the organic device - and subsequently an alternating series of SiOₓ-based and perfluorohexane-based layers 9, 8.

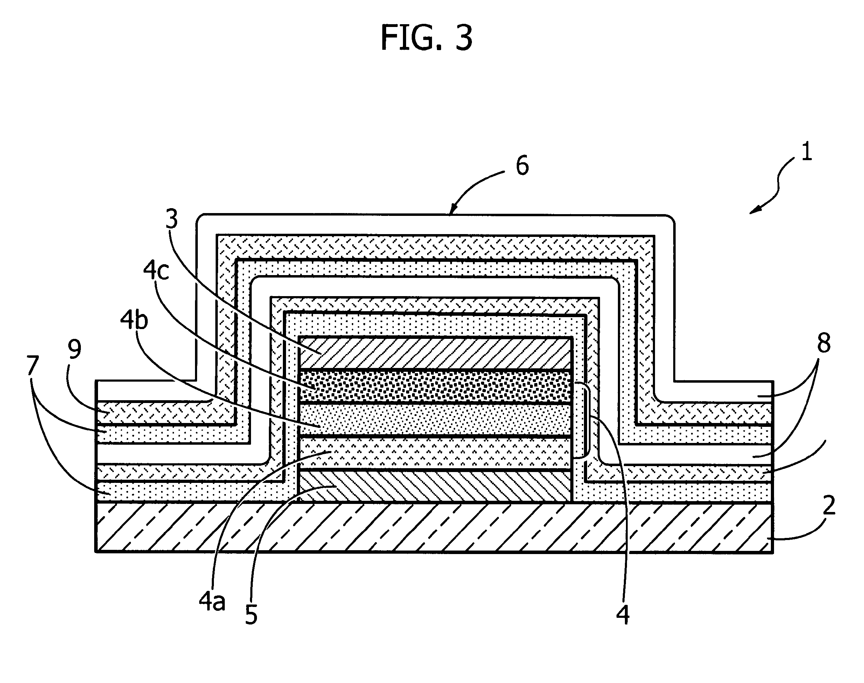

In a different embodiment (as illustrated in Figure 3), the multilayer coating 6 can include a first hexamethyldisiloxane-based layer 7 - in direct contact with the organic device - , an SiOₓ-based intermediate layer 9, and one second perfluorohexane-based layer 8, where the sandwich structure of the three layers 7, 9, 8 can be repeated a number of times.

The deposition of the multilayer protective coating must be obtained in conditions of a not particularly high temperature in order not to damage the light-emitting organic layers of the organic optical device. The technical solution described herein may be obtained in the conditions of temperature necessary for preventing damage to the optical device.

In general terms, the application of the multilayer protective coating on an organic optical device is obtained in two steps. In a first step, the first hexamethyldisiloxane-based layer is deposited in a high-vacuum chamber provided with an RF magnetron sputtering system for plasma-assisted polymerization of hexamethyldisiloxane. Next, the second perfluorohexane-based hydrophobic layer is applied by means of evaporation in a vacuum in a deposition chamber separate from the chamber for deposition of the hexamethyldisiloxane. It is important, during production of the multilayer coating, to avoid exposure of the device to air.

Provision of the first hexamethyldisiloxane-based layer takes place in a high-vacuum chamber in which the monomers of hexamethyldisiloxane are introduced in the gas phase at a temperature of approximately 80°C.

The operating conditions of the RF magnetron sputtering system can vary in the following range of values:
- flow of hexamethyldisiloxane comprised between 20 and 40 ml/min;
- power density of the plasma generated comprised between 0.1 W/cm³ and 0.4 W/cm³.

The times for deposition of the polymeric layer can range between 15 minutes and one hour to obtain layers of variable thickness of between a few tens of nanometres and a few microns.

The geometry of the plasma is optimized to obtain a polymeric layer as compact as possible in an endeavour to minimize the number of pinholes present on the surface. The verification of the presence and of the dimensions of pinholes is controlled by means of an atomic-force microscope.

The conditions of hydrophobicity of the polymeric layer are guaranteed by the presence of methyl radicals in the polymer. The uniformity of the presence of methyl radicals in the multilayer coating deposited is controlled by means of an IR confocal microscope.

By varying the RF power of the magnetron, as well as the flow with which the hexamethyldisiloxane monomer is introduced into the chamber, it is possible to vary the chemico-physical properties of this layer, to arrive at the formation of an SiOₓ-based inorganic layer 9. In conditions of high-power and low-pressure plasma of the monomer in the deposition chamber (dynamic pressure in the region of 2.0 10⁻³ mbar) the methyl radicals present on the siloxane structure can in fact be detached and removed completely. It is thus possible to provide a layer of an extremely compact SiOₓ-based inorganic type. In said conditions, it is useful to insert within the chamber a grid charged at a negative potential to collect the ions that have formed in the plasma and prevent an ion bombardment of the optical device, which could be damaged.

The perfluorohexane layer is deposited on the hexamethyldisiloxane layer. The deposition is made by means of evaporation in a vacuum (with pressures in the region of 10⁻⁵-10⁻⁶ mbar) of perfluorohexane in the form of powder at crucible temperatures ranging between 80°C and 100°C, in a deposition chamber separate from the one for deposition of the hexamethyldisiloxane.

The thickness of the perfluorohexane-based layers may also range from a few nanometres to a few microns.

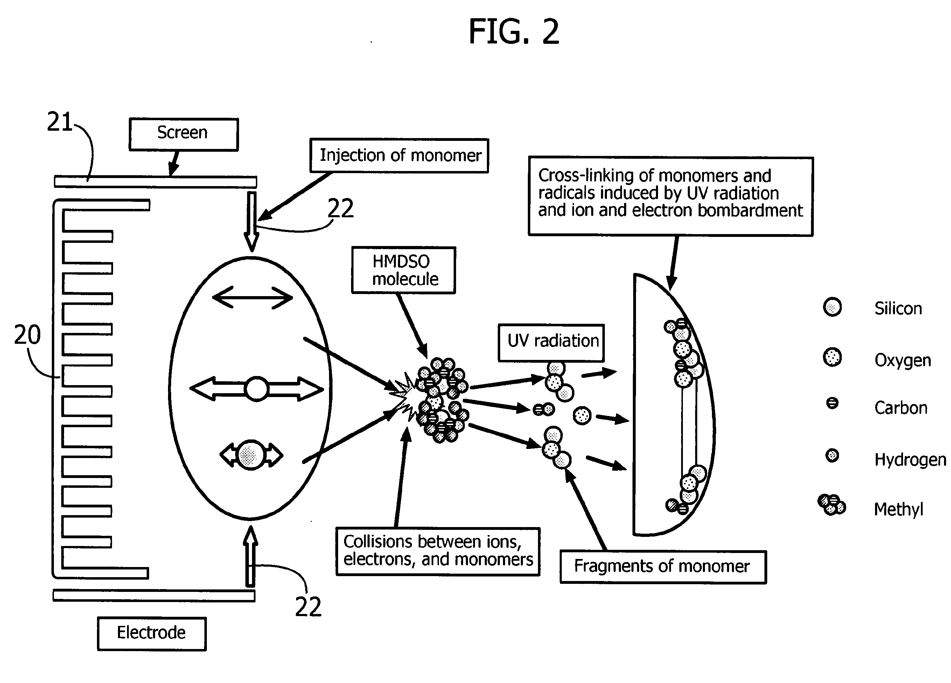

Illustrated in schematic form in Figure 2 is the process of plasma-assisted polymerization of hexamethyldisiloxane. Plasma-assisted polymerization is conducted in a vacuum chamber including an electrode 20, shielded laterally by shields 21, and means 22 for the injection of hexamethyldisiloxane in a gaseous form, which by action of the plasma, and consequently of the ion and electron bombardament to which it is subjected, is fragmented, releasing methyl radicals and undergoes crosslinking on the exposed surface of the organic optical device 1, generating a polymeric layer.

Of course, the details of production and the embodiments may vary widely with respect to what is described and illustrated, without thereby departing from the scope of the present invention, as defined by the annexed claims.

## Claims

1. A multilayer coating (6) for protecting an organic optical device (1), the coating (6) including at least one first layer (7) and one second layer (8), **characterized in that** said first layer (7) is constituted by a hexamethyldisiloxane-based polymeric layer, and said second layer (8) is constituted by a perfluorohexane-based inorganic layer,
wherein said multilayer coating (6) includes at least one first hexamethyldisiloxane-based polymeric layer (7), at least one second perfluorohexane-based inorganic layer (8), and at least one intermediate layer (9) between said first layer (7) and said second layer (8), said intermediate layer (9) being constituted by an SiOₓ-based inorganic layer.

2. The multilayer coating according to Claim 1 , wherein said multilayer coating includes from two to twelve layers.

3. The multilayer coating according to any one of the preceding claims, wherein said first layer (7) has a thickness ranging between 10 nm and 100 µm, preferably between 100 nm and 1 µm, even more preferably between 1 µm and 10 µm.

4. The multilayer coating according to any one of the preceding claims, wherein said second layer (8) has a thickness ranging between 10 nm and 100 µm, preferably between 10 nm and 100 nm, even more preferably between 10 nm and 30 nm.

5. The multilayer coating according to any one of Claims 2 to 4, wherein said intermediate layer (9) has a thickness ranging between 10 nm and 100 µm, preferably between 10 nm and 100 nm, even more preferably between 10 nm and 50 nm.

6. The multilayer coating according to any one of the preceding claims, wherein said multilayer coating is substantially without pinholes having a diameter greater than 5 nm.

7. A process for providing a multilayer coating (6) according to any one of Claims 1 to 6 on an organic optical device (1), said process being **characterized in that** envisages the following operations:
i) providing hexamethyldisiloxane in a gaseous form,
ii) proceeding to deposition of said hexamethyldisiloxane on a surface of said organic optical device by means of plasma-assisted polymerization of said hexamethyldisiloxane so as to form a first hexamethyldisiloxane-based polymeric layer (7) on said surface of said organic optical device,
iii) providing perfluorohexane in the form of powder,
iv) proceeding to the deposition by means of evaporation of said perfluorohexane on said first layer so as to form a second perfluorohexane-based inorganic layer (8) on said first layer,
said operations being conducted in a vacuum,
wherein set between said first hexamethyldisiloxane-based polymeric layer (7) and said second perfluorohexane-based inorganic layer (8) is an intermediate layer (9) constituted by an inorganic SiOₓ-based layer, and wherein said intermediate SiOₓ-based inorganic layer (9) is obtained with the following operations:
a) providing hexamethyldisiloxane in a gaseous form with a flow comprised between 0.1 and 5 ml/min;
b) proceeding to deposition of said intermediate layer by means of plasma-assisted polymerization of said hexamethyldisiloxane at a power density of the plasma comprised between 0.5 and 2.0 W/cm³ so as to form said intermediate SiOₓ-based inorganic layer on said first hexamethyldisiloxane-based polymeric layer, said operations being conducted in a vacuum.

8. The process according to Claim 7 wherein said polymerization of said hexamethyldisiloxane is conducted in a high-vacuum chamber.

9. The process according to either Claim 7 or Claim 8, wherein said deposition of said hexamethyldisiloxane in polymeric form is conducted using an RF magnetron sputtering system.

10. The process according to any one of Claims 7 to 9, wherein said hexamethyldisiloxane in a gaseous form is provided at a temperature of approximately 80°C.

11. The process according to any one of Claims 7 to 10, wherein said hexamethyldisiloxane in a gaseous form is provided with a flow comprised between 20 and 40 ml/min.

12. The process according to any one of Claims 7 to 11, wherein said polymerization of said hexamethyldisiloxane is conducted with a power density of the plasma of between 0.1 and 0.4 W/cm³.

13. The process according to any one of Claims 7 to 12, wherein said deposition by means of evaporation of said perfluorohexane is conducted in a high-vacuum chamber, preferably at a pressure comprised between 10⁻⁵ and 10⁻⁶ mbar.

14. The process according to any one of Claims 7 to 13, wherein said deposition by means of evaporation of said perfluorohexane is conducted at a temperature comprised between 80 and 100°C.

15. An organic optical device including a multilayer coating (6) according to any one of Claims 1 to 6.

## Patentansprüche

1. Mehrschichtige Beschichtung (6) zum Schutz einer organischen optischen Einrichtung (1), wobei die Beschichtung (6) wenigstens eine erste Schicht (7) und eine zweite Schicht (8) umfasst, **dadurch gekennzeichnet, dass** die erste Schicht (7) aus einer auf Hexamethyldisiloxan basierenden Polymerschicht besteht, und die zweite Schicht (8) aus einer auf Perfluorhexan basierenden anorganischen Schicht besteht, wobei die mehrschichtige Beschichtung (6) wenigstens eine erste auf Hexamethyldisiloxan basierende Polymerschicht (7), wenigstens eine zweite auf Perfluorhexan basierende anorganische Schicht (8) und wenigstens eine Zwischenschicht (9) zwischen der ersten Schicht (7) und der zweiten Schicht (8) umfasst, wobei die Zwischenschicht (9) aus einer auf SiOₓ basierenden anorganischen Schicht besteht.

2. Mehrschichtige Beschichtung nach Anspruch 1, wobei die mehrschichtige Beschichtung zwei bis zwölf Schichten umfasst.

3. Mehrschichtige Beschichtung nach einem der vorangehenden Ansprüche, wobei die erste Schicht (7) eine Dicke in dem Bereich zwischen 10 nm und 100 µm aufweist, vorzugsweise zwischen 100 nm und 1 µm, noch bevorzugter zwischen 1 µm und 10 µm.

4. Mehrschichtige Beschichtung nach einem der vorangehenden Ansprüche, wobei die zweite Schicht (8) eine Dicke in dem Bereich von 10 nm und 100 µm aufweist, vorzugsweise zwischen 10 nm und 100 nm, noch bevorzugter zwischen 10 nm und 30 nm.

5. Mehrschichtige Beschichtung nach einem der Ansprüche 2 bis 4, wobei die Zwischenschicht (9) eine Dicke in dem Bereich zwischen 10 nm und 100 µm aufweist, vorzugsweise zwischen 10 nm und 100 nm, noch bevorzugter zwischen 10 nm und 50 nm.

6. Mehrschichtige Beschichtung nach einem der vorangehenden Ansprüche, wobei die mehrschichtige Beschichtung im Wesentlichen keine Nadellöcher mit einem Durchmesser von mehr als 5 nm aufweist.

7. Verfahren zur Bereitstellung einer mehrschichtigen Beschichtung (6) nach einem der Ansprüche 1 bis 6 auf einer organischen optischen Einrichtung (1), wobei das Verfahren **dadurch gekennzeichnet ist, dass** es die folgenden Verfahren vorsieht:
i) Bereitstellen von Hexamethyldisiloxan in einer Gasform,
ii) Fortschreiten der Abscheidung des Hexamethyldisiloxans auf einer Oberfläche der organischen optischen Einrichtung mittels einer plasmaunterstützten Polymerisation des Hexamethyldisiloxans, um so eine erste auf Hexamethyldisiloxan basierende Polymerschicht (7) auf der Oberfläche der organischen optischen Einrichtung zu bilden,
iii) Bereitstellen von Perfluorhexan in der Form eines Pulvers,
iv) Fortschreiten der Abscheidung durch Verdampfung des Perfluorhexans auf der ersten Schicht, um so eine zweite auf Perflouohexan basierende anorganische Schicht (8) auf der ersten Schicht zu bilden,
wobei die Verfahren in einem Vakuum durchgeführt werden,
wobei zwischen der ersten auf Hexamethyldisiloxan basierende Polymerschicht (7) und der zweiten auf Perfluorhexan basierenden anorganischen Schicht (8) eine Zwischenschicht (9) angeordnet ist, welche aus einer anorganischen auf SiOₓ basierenden Schicht besteht, und wobei die auf SiOₓ basierende anorganische Zwischenschicht (9) durch die folgenden Verfahren erhalten wird:
a) Bereitstellen von Hexamethyldisiloxan in der Form eines Gases mit einem Fluss von zwischen 0,1 und 5 ml/min;
b) Fortschreiten der Abscheidung der Zwischenschicht mittels plasmaunterstützter Polymerisation des Hexamethyldisiloxans mit einer Energiedichte des Plasmas von zwischen 0,5 und 2,0 W/cm³, um so die auf SiOₓ basierende anorganische Zwischenschicht auf der ersten Hexamethyldisiloxan basierenden Polymerschicht zu bilden, wobei die Verfahren in einem Vakuum durchgeführt werden.

8. Verfahren nach Anspruch 7, wobei die Polymerisation des Hexamethyldisiloxans in einer Hochvakuumkammer durchgeführt wird.

9. Verfahren nach Anspruch 7 oder 8, wobei das Abscheiden des Hexamethyldisiloxans in Polymerform unter Verwendung eines RF-Magnetronsputtersystems durchgeführt wird.

10. Verfahren nach einem der Ansprüche 7 bis 9, wobei das Hexamethyldisiloxan in Gasform bei einer Temperatur von ungefähr 80°C bereitgestellt wird.

11. Verfahren nach einem der Ansprüche 7 bis 10, wobei das Hexamethyldisiloxan in Gasform mit einem Fluss bzw. einer Strömung von zwischen 20 und 40 ml/min bereitgestellt wird.

12. Verfahren nach einem der Ansprüche 7 bis 11, wobei die Polymerisation des Hexamethyldisiloxans mit einer Energiedichte des Plasmas zwischen 0,1 und 0,4 W/cm³ durchgeführt wird.

13. Verfahren nach einem der Ansprüche 7 bis 12, wobei die Abscheidung durch Verdampfung des Perflourhexans in einer Hochvakuumkammer durchgeführt wird, vorzugsweise bei einem Druck zwischen 10⁻⁵ und 10⁻⁶ bar.

14. Verfahren nach einem der Ansprüche 7 bis 13, wobei die Abscheidung mittels der Verdampfung des Perflourhexans bei einer Temperatur zwischen 80 und 100°C durchgeführt wird.

15. Organische optische Einrichtung umfassend eine mehrschichtige Beschichtung (6) gemäß einem der Ansprüche 1 bis 6.

## Revendications

1. Revêtement multicouche (6) pour protéger un dispositif optique organique (1), le revêtement (6) comprenant au moins une première couche (7) et une deuxième couche (8), **caractérisé en ce que** ladite première couche (7) est constituée d'une couche de polymère à base d'hexaméthyldisiloxane, et ladite deuxième couche (8) étant constituée d'une couche inorganique à base de perfluorohexane,
ledit revêtement multicouche (6) comprenant au moins une première couche polymère à base d'hexaméthyldisiloxane (7), au moins une deuxième couche inorganique à base de perfluorohexane (8), et au moins une couche intermédiaire (9) entre ladite première couche (7) et ladite deuxième couche (8), ladite couche intermédiaire (9) étant constituée d'une couche inorganique à base de SiOₓ.

2. Revêtement multicouche selon la revendication 1, ledit revêtement multicouche comprenant de deux à douze couches.

3. Revêtement multicouche selon l'une quelconque des revendications précédentes, ladite première couche (7) ayant une émission dans la plage comprise entre 10 nm et 100 µm, de préférence entre 100 nm et 1 µm, encore plus préférablement entre 1 µm et 10 µm.

4. Revêtement multicouche selon l'une quelconque des revendications précédentes, ladite deuxième couche (8) ayant une épaisseur comprise entre 10 nm et 100 µm, de préférence entre 10 nm et 100 nm, encore plus préférablement entre 10 nm et 30 nm.

5. Revêtement multicouche selon l'une quelconque des revendications 2 à 4, ladite couche intermédiaire (9) ayant une épaisseur dans la plage comprise entre 10 nm et 100 µm, de préférence entre 10 nm et 100 nm, encore plus préférablement entre 10 nm et 50 nm.

6. Revêtement multicouche selon l'une quelconque des revendications précédentes, ledit revêtement multicouche étant sensiblement sans trous d'aiguille ayant un diamètre supérieur à 5 nm.

7. Procédé pour produire un revêtement multicouche (6) selon l'une quelconque des revendications 1 à 6 sur un dispositif optique organique (1), ledit procédé étant **caractérisé en ce qu'**il comprend les opérations suivantes :
i) fourniture d'hexaméthyldisiloxane sous une forme gazeuse,
ii) conduite du dépôt dudit hexaméthyldisiloxane sur une surface dudit dispositif optique organique au moyen d'une polymérisation assistée par plasma dudit hexaméthyldisiloxane de manière à former une première couche de polymère à base d'hexaméthyldisiloxane (7) sur ladite surface dudit dispositif optique organique,
iii) fourniture de perfluorohexane sous la forme d'une poudre,
iv) conduite du dépôt au moyen de l'évaporation dudit perfluorohexane sur ladite première couche de manière à former une deuxième couche inorganique à base de perfluorohexane (8) sur ladite première couche,
lesdites opérations étant conduites sous vide,
où, entre ladite première couche de polymère à base d'hexaméthyldisiloxane (7) et ladite deuxième couche inorganique à base de perfluorohexane (8) est disposé une couche intermédiaire (9) constituée d'une couche à base de SiOₓ inorganique, et ladite couche inorganique à base de SiOₓ intermédiaire (9) est obtenue par les opérations suivantes :
a) fourniture d'hexaméthyldisiloxane sous une forme gazeuse avec un débit compris entre 0,1 et 5 ml/min ;
b) conduite du dépôt de ladite couche intermédiaire au moyen d'une polymérisation assistée par plasma dudit hexaméthyldisiloxane à une densité de puissance du plasma comprise entre 0,5 et 2,0 W/cm³ de manière à former ladite couche inorganique à base de SiOₓ intermédiaire sur ladite première couche polymère à base d'hexaméthyldisiloxane, lesdites opérations étant conduites sous vide.

8. Procédé selon la revendication 7, dans lequel ladite polymérisation dudit hexaméthyldisiloxane est conduite dans une chambre à vide poussé.

9. Procédé selon la revendication 7 ou la revendication 8, ledit dépôt dudit hexaméthyldisiloxane sous forme polymère étant conduit en utilisant un système de pulvérisation à magnétron RF.

10. Procédé selon l'une quelconque des revendications 7 à 9, ledit hexaméthyldisiloxane sous une forme gazeuse étant fourni à une température d'approximativement 80 °C.

11. Procédé selon l'une quelconque des revendications 7 à 10, ledit hexaméthyldisiloxane sous une forme gazeuse étant fourni à un débit compris entre 20 et 40 ml/min.

12. Procédé selon l'une quelconque des revendications 7 à 11, dans lequel ladite polymérisation dudit hexaméthyldisiloxane est conduite avec une densité de puissance du plasma comprise entre 0,1 et 0,4 W/cm³.

13. Procédé selon l'une quelconque des revendications 7 à 12, dans lequel ledit dépôt au moyen de l'évaporation dudit perfluorohexane est conduit dans une chambre à vide poussé, de préférence à une pression comprise entre 10⁻⁵ et 10⁻⁶ mbar.

14. Procédé selon l'une quelconque des revendications 7 à 13, dans lequel ledit dépôt au moyen de l'évaporation dudit perfluorohexane est conduit à une température comprise entre 80 et 100 °C.

15. Dispositif optique organique comprenant un revêtement multicouche (6) selon l'une quelconque des revendications 1 à 6.
